# EUROPÄISCHE PATENTSCHRIFT

(11) **EP 1 683 244 B1**
(45) Veröffentlichungstag und Bekanntmachung des Hinweises auf die Patenterteilung: **10.09.2008**
(21) Anmeldenummer: 04802693.4
(22) Anmeldetag: 09.11.2004
(51) Int. Cl.: H01S 5/183, H01S 5/04

(54) **OPTISCH GEPUMPTE HALBLEITERLASERVORRICHTUNG**
OPTICALLY PUMPED SEMICONDUCTOR LASER DEVICE
DISPOSITIF LASER A SEMI-CONDUCTEUR A POMPAGE OPTIQUE

(30) Priorität: 13.11.2003 DE 10353215
(43) Veröffentlichungstag der Anmeldung: 26.07.2006
(73) Patentinhaber: OSRAM Opto Semiconductors GmbH, 93055 Regensburg (DE)
(72) Erfinder: SCHMID, Wolfgang, 93180 Deuerling (DE); BRICK, Peter, 93051 Regensburg (DE); LUTGEN, Stephan, 93047 Regensburg (DE); ALBRECHT, Tony, 93077 Bad Abbach (DE); EBERHARD, Franz, 93059 Regensburg (DE)
(74) Vertreter: Epping - Hermann - Fischer
(86) Internationale Anmeldenummer: PCT/DE2004/002476
(87) Internationale Veröffentlichungsnummer: WO 2005/048423

(56) Entgegenhaltungen:
- DE-A1- 10 026 734
- DE-A1- 10 108 079
- US-A1- 2002 075 935
- PATENT ABSTRACTS OF JAPAN Bd. 1996, Nr. 01, 31. Januar 1996 (1996-01-31) & JP 07 249824 A (HITACHI LTD), 26. September 1995 (1995-09-26)

## Beschreibung

Die vorliegende Erfindung betrifft eine optisch gepumpte Halbleiterlaservorrichtung mit einem oberflächenemittierenden Vertikalemissionsbereich und mindestens einer monolithisch integrierten Pumpstrahlungsquelle zum optischen Pumpen des Vertikalemissionsbereichs.

Derartige Laservorrichtungen sind beispielsweise aus den Druckschriften WO 01/93386 und WO 02/067393 bekannt. In den Druckschriften werden oberflächenemittierende Halbleiterlaservorrichtungen beschrieben, deren aktives Element des Vertikalemissionsbereichs durch eine Quantentopf-struktur gebildet wird, die von angrenzenden kantenemittierenden Halbleiterlasern optisch gepumpt wird. Pumpstrahlungsquelle und Quantentopfstruktur sind epitaktisch auf einem gemeinsamen Substrat aufgewachsen. Die so entstehende monolithisch integrierte Anordnung ist platzsparend und kostengünstig herstellbar. Weiterhin ist durch den Herstellungsprozess eine genaue Positionierung von Pumpstrahlungsquelle und Vertikalemissionsbereich zueinander gewährleistet.

Optisch gepumpte Halbleiterlaservorrichtungen der genannten Art erlauben eine hohe Ausgangsleistung, da die Verlustleistungsquellen, Widerstandsverluste bei der Ladungsträgerinjektion beim elektrischen Pumpen zum einen und optische Absorptionsverluste zum anderen, räumlich getrennt sind. Gleichzeitig weisen sie ein vorteilhaftes rundes Strahlprofil auf und nicht, wie beispielsweise ein kantenemittierender Laser, ein elliptisches oder strichförmiges Strahlprofil.

Eine gute Strahlqualität ergibt sich insbesondere bei Laserstrahlung in der Grundmode TEM₀₀ des Vertikalemissionsbereichs.

Aus der Druckschrift JP 07249824 A ist eine optisch gepumpte Halbleiterlaservorrichtung mit Vertikalemitter bekannt, bei der mehrere monolithisch integrierte Pumpstrahlungsquellen zum optischen Pumpen des Vertikalemitters vorgesehen sind. Die Pumpstrahlung tritt aus verschiedenen Richtungen in den Vertikalemitter ein, wodurch die Anregung der Grundmode gefördert wird.

Die Druckschrift US 2002/0075935 A1 offenbart einen optisch gepumpten Vertikalemitter mit Pumpstrahlungsquellen mit gekrümmten Spiegeln und/oder einem gekrümmten Übergangsbereich zwischen Pumpstrahlungsquelle und Vertikalemitter. Als Folge tritt die Pumpstrahlung aus verschieden Richtungen in den Vertikalemitter ein, wodurch wiederum die Anregung der Grundmode gefördert wird.

Es ist eine Aufgabe der vorliegenden Erfindung, eine optisch gepumpte Halbleiterlaservorrichtung mit mindestens zwei monolithisch integrierten Pumpstrahlungsquellen zu schaffen, die Laserstrahlung in guter Strahlqualität, bevorzugt Strahlung der Grundmode, emittiert und sich durch eine hohe Effizienz auszeichnet.

Diese Aufgabe wird mit einer optisch gepumpten Halbleiterlaservorrichtung mit den Merkmalen des Patentanspruchs 1 gelöst. Vorteilhafte Weiterbildungen der Erfindung sind Gegenstand der abhängigen Ansprüche.

Erfindungsgemäß ist vorgesehen, dass die mindestens zwei Pumpstrahlungsquellen so eingerichtet und angeordnet ist, dass die Pumpstrahlung in Form von Teilstrahlungsbündeln, die von verschiedenen Pumpstrahlungsquellen mit verschiedener Hauptstrahlungsrichtung stammen, mit unterschiedlichen Strahlungsrichtungen in den Vertikalemissionsbereich eintritt, sodass die Pumpstrahlung einen Überlapp mit der Grundmode des Vertikalemissionsbereichs aufweist, der zur Anregung dieser Grundmode geeignet ist. Mindestens eine der Pumpstrahlungsquellen weist dabei einen Resonator mit mindestens einer Resonatorendspiegelanordnung auf, die aus zwei geraden Resonatorendspiegeln besteht, die rechtwinklig zueinander angeordnet sind, oder mindestens eine der Pumpstrahlungsquellen weist einen gefalteten Resonator mit zwei Resonatorendspiegeln und mindestens einem inneren Resonatorspiegel auf.

Es wird gerade dann Strahlung der gewünschten Grundmode des Vertikalemissionsbereichs abgegeben, wenn die räumliche Intensitätsverteilung der Pumpstrahlung im Vertikalemissionsbereich dem Profil dieser Grundmode angepasst ist. Typischerweise ist die Grundfläche des Vertikalemissionsbereichs ein Vieleck (Viereck, Sechseck etc.) oder ein Kreis. In der Grundmode spiegelt sich die Symmetrie der Grundfläche des Vertikalemissionsbereichs wider. Zur Anregung der Grundmode ist es daher günstig, die Pumpstrahlung in Form Teilstrahlungsbündeln mit unterschiedlichen Strahlungsrichtungen in den Vertikalemissionsbereich einzukoppeln, wodurch die räumliche Intensitätsverteilung der Pumpstrahlung dem Profil der Grundmode angepasst werden kann. Als Teilstrahlungsbündel mit unterschiedlichen Strahlungsrichtungen ist auch eine Einkopplung anzusehen, bei der die Pumpstrahlung konvergierend in den Vertikalemissionsbereich eintritt.

Besonders bevorzugt ist dabei, dass die Pumpstrahlungsquellen Halbleiterlaserelemente mit einem geschlossenen Resonator sind, der den Verstärkerbereich umfasst. Alternativ können die Pumpstrahlungsquellen kantenemittierende Halbleiterlaser sein.

In einer weiteren begünstigten Ausführungsform sind die zwei Resonatorendspiegel so angeordnet, dass die Pumpstrahlung im Resonator an ihnen Totalreflexion erfährt.

Eine weitere Ausführungsform ist ist besonders bevorzugt, dass der mindestens eine innere Resonatorspiegel so angeordnet ist, dass die Pumpstrahlung im Resonator Totalreflexion an ihm erfährt. Die Resonatorendspiegel können dabei gebrochene Kristallfacetten und die inneren Resonatorspiegel geätzte Spiegel sein.

Eine vorteilhafte Weiterbildung der erfindungsgemäßen Halbleiterlaservorrichtung ist, dass der Übergang von der mindestens einen Pumpstrahlungsquelle zum Vertikalemissionsbereich gekrümmt ist und sich durch eine Brechungszahländerung auszeichnet, sodass die Pumpstrahlung im Vertikalemissionsbereich fokussiert wird.

Weitere Vorteile, vorteilhafte Ausgestaltungen und Weiterbildungen der Halbleiterlaservorrichtung ergeben sich aus den im Folgenden in Verbindung mit den Figuren 1 bis 6 näher erläuterten Ausführungsbeispielen. Es zeigen:
Figur 1 eine schematische Darstellung einer Aufsicht auf eine Halbleiterlaservorrichtung,
Figur 2 eine schematische Darstellung einer Aufsicht auf eine weitere Halbleiterlaservorrichtung,
Figur 3 eine schematische Darstellung einer Aufsicht auf ein erstes Ausführungsbeispiel einer erfindungsgemäßen Halbleiterlaservorrichtung,
Figur 4 eine schematische Darstellung einer Aufsicht auf ein zweites Ausführungsbeispiel einer erfindungsgemäßen Halbleiterlaservorrichtung,
Figur 5 eine schematische Darstellung einer Aufsicht auf eine weitere Halbleiterlaservorrichtung und
Figur 6 eine schematische Darstellung einer Aufsicht auf eine weitere Halbleiterlaservorrichtung.

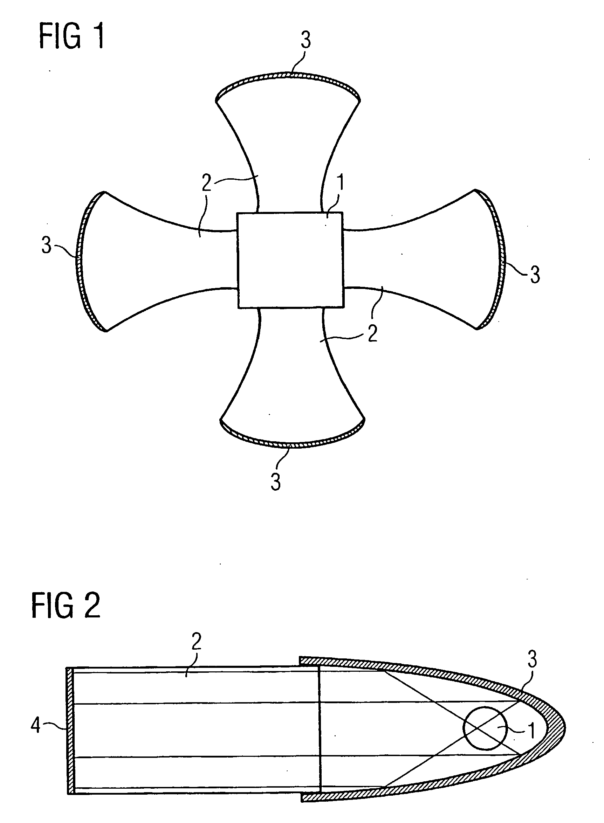

Bei den in den Figuren 1, 2, 5 und 6 gezeigten Halbleiterlaservorrichtungen handelt es sich nicht um Ausführungsbeispiele der Erfindung, sondern lediglich um Beispiele, das das Verständnis der Erfindung erleichtern.

Die Figuren sind schematische Zeichnungen. Insbesondere sind die Größenverhältnisse der Elemente nicht maßstabsgerecht dargestellt. Gleiche oder gleich wirkende Elemente der verschiedenen Ausführungsbeispiele sind in den Figuren jeweils mit denselben Bezugszeichen versehen.

Das in Figur 1 schematisch in der Aufsicht gezeigte optisch gepumpten Halbleiterlaservorrichtung weist einen zentralen Vertikalemissionsbereich 1 und zwei sich in dem Vertikalemissionsbereich 1 kreuzende Pumpstrahlungsquellen 2 auf. Die Pumpstrahlungsquellen 2 sind nach außen durch gekrümmte Resonatorendspiegel 3 begrenzt.

Eine geeignete Halbleiterschichtabfolge zur Realisierung dieses oder eines im Rahmen dieser Anmeldung gezeigten Ausführungsbeispieles einer Halbleiterlaservorrichtung kann beispielsweise einer der eingangs genannten Druckschriften WO 01/93386 oder WO 02/067393 entnommen werden. Der Vertikalemissionsbereich 1 kann beispielsweise Quantentopstrukturen als aktive verstärkende Bereiche aufweisen, wobei die Bezeichnung Quantentopfstruktur im Rahmen der Anmeldung jegliche Struktur umfasst, bei der Ladungsträger durch Einschluss (confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Die gekrümmten Resonatorendspiegel 3 lassen sich bei den monolithisch integrierten Pumplasern 2 durch einen Ätzprozess in beliebiger Form und mit beliebigem Krümmungsradius herstellen. Die gewünschte Reflektivität lässt sich in einem weiteren Herstellungsprozess ggf. durch Aufbringen einer Metallisierung erzielen. Bei geeigneter Formgebung der Resonatorendspiegel 3 entsteht auf diese Weise ein Laserresonator für die Pumpstrahlungsquellen 2, der sich durch die Ausbildung stabiler resonatorinterner Pumpstrahlungsmoden mit einem ideal gauß-förmigen lateralen Intensitätsprofil auszeichnet.

Bedingt durch die Strahlenführung im Resonator treten die Strahlenbündel konvergent in den Vertikalemissionsbereich 1 ein, was eine Konzentration der Intensität im Zentrum des Vertikalemissionsbereichs 1 zur Folge hat. Zusammen mit dem gauß-förmigen lateralen Intensitätsprofil der Pumpstrahlung ergibt sich eine räumliche Verteilung der Pumpstrahlung im Vertikalemissionsbereich 1, die in guter Näherung der Grundmode des Vertikalemissionsbereichs 1 entspricht.

Dabei ist es günstig, wenn der Absorptionskoeffizient der Pumpstrahlung im Vertikalemissionsbereich 1 so eingestellt wird, dass die Absorption der Pumpstrahlung im Randbereich des Vertikalemissionsbereichs 1 nicht so stark ist, dass keine Pumpstrahlung mehr bis in das Zentrum des Vertikalemissionsbereichs 1 vordringen kann. Eine Anpassung dieses Absorptionskoeffizienten kann durch geeignete Wahl der Wellenlänge der Pumpstrahlung verglichen mit der Wellenlänge der emittierten Strahlung aus dem Vertikalemissionsbereich 1 erfolgen, welche wiederum durch die Materialzusammensetzung der optisch aktiven Strukturen im Vertikalemissionsbereich 1 und den Pumpstrahlungsquellen 2 beeinflusst werden kann. Zum Erreichen einer guten Pumpeffizienz hat dabei die Pumpstrahlung eine kleinere Wellenlänge als die vom Vertikalemissionsbereich 1 abgegebene Strahlung.

Bei der in Figur 2 gezeigten Halbleiterlaservorrichtung ist eine Pumpstrahlungsquelle 2 vorgesehen, die einen geraden Resonatorendspiegel 4 und einen gekrümmten Resonatorendspiegel 3 aufweist. Der gerade Resonatorendspiegel 4 ist idealerweise eine gespaltene Kristallfacette. Der gekrümmte Resonatorendspiegel 3 ist wiederum durch einen Ätzprozess erstellt. Beide Spiegelflächen können mit einer nachfolgenden Metallisierung versehen sein. Bevorzugt hat der gekrümmte Resonatorendspiegel 3 die Form einer Parabel, deren Symmetrieachse in Richtung der Pumpstrahlungsquelle 2 und senkrecht zum geraden Resonatorendspiegel 4 verläuft. Der Bereich des Vertikalemissionsbereichs 1 ist in diesem Ausführungsbeispiel rund ausgeführt und im Brennpunkt der Parabel angeordnet. Somit tritt Pumpstrahlung aus allen Richtungen homogen in den Vertikalemissionsbereich 1 ein. Dieses resultiert in einer radialsymmetrischen Verteilung der Pumpstrahlungsintensität im Vertikalemissionsbereich 1, wodurch idealerweise die ebenfalls radialsymmetrische Grundmode des Vertikalemissionsbereichs 1 gepumpt wird.

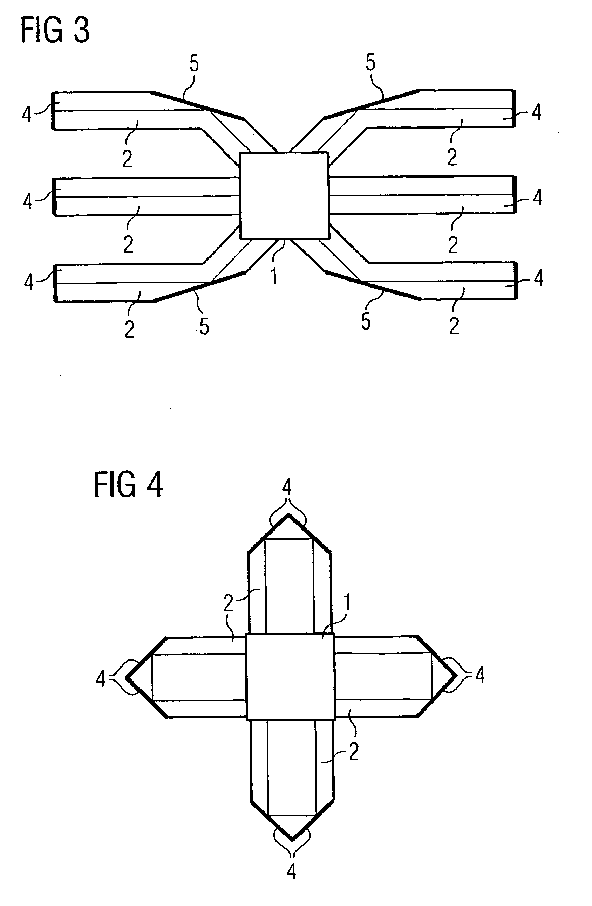

Bei dem in Figur 3 gezeigten ersten Ausführungsbeispiel einer erfindungsgemäßen Halbleiterlaservorrichtung ist der Vertikalemissionsbereich 1 von drei sich in diesem Vertikalemissionsbereich 1 kreuzenden Pumpstrahlungsquellen 2 umgeben. Dabei zeichnet sich die mittlere der Pumpstrahlungsquellen 2 durch einen linearen Resonator aus, der durch zwei gerade Resonatorendspiegel 4 begrenzt ist. Die beiden weiteren Pumpstrahlungsquellen 2 sind ebenfalls durch je zwei gerade Resonatorendspiegel 4 begrenzt, weisen darüber hinaus zusätzlich je zwei innere Resonatorspiegel 5 auf.

Die in Figur 3 dargestellte Anordnung führt zu Ein- bzw. Ausfallwinkeln der resonatorinternen Strahlung an den inneren Resonatorspiegeln 5 von 45°. Bei den Brechungsindizes von Materialien, wie sie typischerweise für eine Halbleiterlaservorrichtung der gezeigten Art eingesetzt werden, tritt bei diesem Winkel bereits Totalreflexion an den Grenzflächen der inneren Resonatorspiegel 5 auf. Die inneren Resonatorspiegel 5 können beispielsweise in einem Ätzprozess hergestellt werden, wobei auf eine zusätzliche Metallisierung zur Verspiegelung verzichtet werden kann. Als Ätzprozess kommt bevorzugt ein nass- oder trockenchemisches Ätzverfahren in Frage. Es kann eine inerte Passivierungsschicht, z.B. Siliziumnitrid, zum Schutz der geätzten Flächen und zu einer Verbesserung der chemischen Langzeitstabilität dieser Flächen aufgebracht werden. In einem besonders geeigneten Herstellungsprozess kann sowohl das Ätzen und/oder das Metallisieren und/oder das Aufbringen einer Passivierungsschicht im Waferverbund durchgeführt werden. Nachfolgend werden dann die Halbleiterlaservorrichtungen durch Sägen oder Brechen voneinander getrennt.

Vorteilhaft an der gezeigten Anordnung ist, dass sich mehrere Pumpstrahlungsquellen 2 mit unterschiedlicher Strahlungsrichtung im Vertikalemissionsbereich 1 überkreuzen und dass die Resonatoren all dieser Pumpstrahlungsquellen durch Resonatorendspiegel 4 begrenzt sind, die aus gespaltenen Kristallfacetten bestehen und daher von hoher Qualität sind. Die zu diesem Zweck notwendigerweise eingeführten inneren Resonatorspiegel 5 haben aufgrund der Totalreflexion keine nachteiligen zusätzlichen Resonatorverluste zur Folge. Der in diesem Ausführungsbeispiel viereckige Vertikalemissionsbereich 1 kann selbstverständlich auch andere Form seiner Grundfläche aufweisen, insbesondere ist hier eine sechseckige Grundfläche denkbar, bei der die Strahlung der Pumpstrahlungsquellen 2 jeweils senkrecht auf eine Seite des Vertikalemissionsbereichs auftrifft.

Abbildung 4 zeigt ein zweites Ausführungsbeispiel, bei dem sich zwei Pumpstrahlungsquellen 2 im zentralen Vertikalemissionsbereich 1 überkreuzen, die an jeder Seite durch jeweils zwei, in einem Winkel von 90° zueinander stehende, gerade Resonatorendspiegel 4 begrenzt werden.

Die Anordnung von jeweils zwei Resonatorendspiegeln 4 ist somit analog zu der Anordnung von Spiegeln in einem Retroreflektor.

Dieses Ausführungsbeispiel nutzt in ähnlicher Weise wie das im Zusammenhang mit Figur 2 geschilderte Beispiel die Totalreflexion aus, um einen Laserresonator mit geringen Reflexionsverlusten zu schaffen. Die geraden Resonatorendspiegel 4 können geätzt sein, wobei auf eine Metallisierung verzichtet werden kann, aber gegebenenfalls eine Schutzschicht zur Passivierung vorgesehen sein kann.

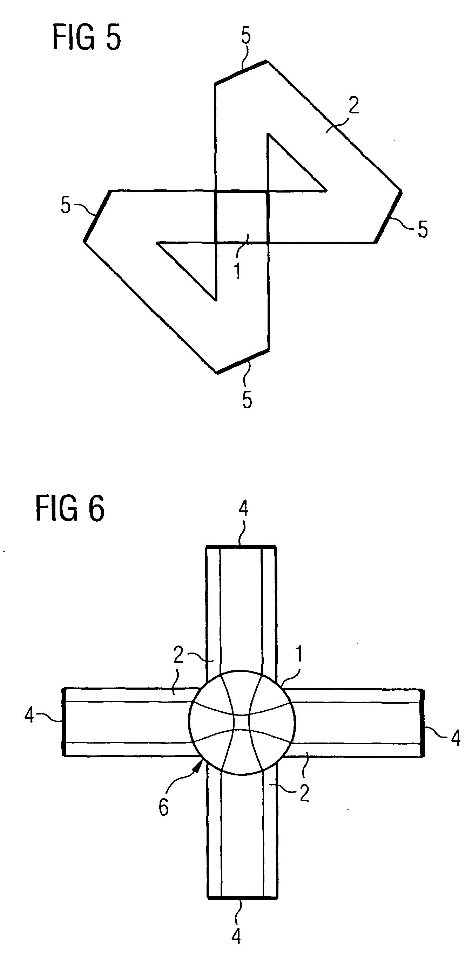

Beim Beispiel in Figur 5 ist nur eine Pumpstrahlungsquelle 2 vorgesehen, die als Halbleiter-Ringlaser mit drei inneren Resonatorspiegeln 5 ausgestattet ist. Der Resonator beschreibt die Form einer "8", wobei der Vertikalemissionsbereich 1 so im Kreuzungspunkt der "8" angeordnet ist, dass Strahlung aus zwei verschiedenen Richtungen durch den Vertikalemissionsbereich 1 geführt wird. Die inneren Resonatorspiegel 5 können in einem Ätzprozess erstellt werden. In der gezeigten Anordnung fällt die Resonatorstrahlung unter einem Winkel von 22,5° auf die inneren Resonatorspiegel 5 auf. Abhängig vom Brechungsindex des eingesetzten Halbleitermaterials tritt auch bei diesem Einfallswinkel Totalreflexion auf. In diesem Fall kann auf eine Verspiegelung der Flächen der inneren Resonatorspiegel 5 verzichtet werden und gegebenenfalls diese lediglich mit einer Passivierungsschicht versehen sein. Im anderen Fall kann statt der Passivierungsschicht eine Metallisierung als Reflexionsbeschichtung aufgebracht sein.

Jede andere Anzahl von Spiegeln ist selbstverständlich auch denkbar und insbesondere dann günstig, wenn aufgrund der Brechungszahl des eingesetzten Halbleitermaterials der Einfallswinkel von 22,5°, der sich bei vier Spiegeln ergibt, nicht ausreicht, um die Bedingung für Totalreflexion zu erfüllen.

Das in Figur 6 gezeigte Beispiel einer erfindungsgemäßen Halbleiterlaservorrichtung zeichnet sich durch einen runden Vertikalemissionsbereich 1 aus. Der Vertikalemissionsbereich 1 wird von vier Seiten von zwei sich in dem Vertikalemissionsbereich 1 kreuzenden Pumpstrahlungsquellen 2 gepumpt. Vertikalemissionsbereich 1 und Pumpstrahlungsquellen 2 sind so ausgelegt, daß sie eine unterschiedliche Brechungszahl aufweisen. Dies kann entweder durch die Wahl der Materialien geschehen oder dadurch, dass eine Stufe in den Übergang zwischen Vertikalemissionsbereich 1 und Pumpstrahlungsquelle 2 eingeätzt wird, die zu unterschiedlichen Impedanzen bei der Wellenleitung und dadurch zu unterschiedlichen effektiven Brechungszahlen führt. Beim Übergang der Pumpstrahlung aus der Pumpstrahlungsquelle 2 in den Vertikalemissionsbereich 1 erfährt die Pumpstrahlung Brechung auf das Zentrum des Vertikalemissionsbereichs 1 hin. Auf diese Weise wird in guter Näherung eine radialsymmetrische Verteilung der Pumpstrahlungsintensität im Vertikalemissionsbereich 1 erreicht, die wiederum die Radialsymmetrie der Grundmode widerspiegelt und diese daher bevorzugt anregt.

Die Erläuterung der Erfindung anhand der Ausführungsbeispiele ist nicht als Beschränkung der Erfindung hierauf zu verstehen. Die Erfindung bezieht sich vielmehr auf sämtliche Anordnungen mit den in den Ansprüchen genannten Merkmalen. Weiterhin umfasst die Erfindung sämtliche in der Beschreibung genannten Merkmale sowie deren Kombination, auch wenn diese nicht in den Ansprüchen oder der Beschreibung explizit genannt sind.

## Patentansprüche

1. Optisch gepumpte Halbleiterlaservorrichtung mit einem oberflächenemittierenden Vertikalemissionsbereich (1) und mindestens zwei monolithisch integrierten Pumpstrahlungsquellen (2) zum optischen Pumpen des Vertikalemissionsbereichs (1), wobei die mindestens zwei Pumpstrahlungsquellen (2) Pumpstrahlung erzeugen und so eingerichtet und angeordnet sind, dass die Pumpstrahlung in Form von Teilstrahlungsbündeln, die von verschiedenen Pumpstrahlungsquellen (2) mit verschiedener Hauptstrahlungsrichtung stammen, mit unterschiedlichen Strahlungsrichtungen in den Vertikalemissionsbereich (1) eintritt, so dass die Pumpstrahlung einen Überlapp mit der Grundmode des Vertikalemissionsbereichs (1) aufweist, der zur Anregung dieser Grundmode geeignet ist,
**dadurch gekennzeichnet, dass**
mindestens eine der Pumpstrahlungsquellen (2) einen Resonator mit mindestens einer Resonatorendspiegelanordnung aufweist, die aus zwei geraden Resonatorendspiegeln (4) besteht, die rechtwinklig zueinander angeordnet sind, oder mindestens eine der Pumpstrahlungsquellen (2) einen gefalteten Resonator mit zwei Resonatorendspiegeln und mindestens einem inneren Resonatorspiegel (5) aufweist.

2. Halbleiterlaservorrichtung nach Anspruch 1, **dadurch gekennzeichnet, dass**
die Pumpstrahlungsquellen (2) kantenemittierende Halbleiterlaser sind.

3. Halbleiterlaservorrichtung nach einem der Ansprüche 1 oder 2, **dadurch gekennzeichnet, dass**
die zwei geraden Resonatorendspiegel (4) so angeordnet sind, dass die Pumpstrahlung im Resonator an ihnen Totalreflexion erfährt.

4. Halbleiterlaservorrichtung nach einem der Ansprüche 1 bis 3, **dadurch gekennzeichnet, dass**
der mindestens eine innere Resonatorspiegel (5) so angeordnet ist, dass die Pumpstrahlung im Resonator Totalreflexion an ihm erfährt.

5. Halbleiterlaservorrichtung nach einem der Ansprüche 1 bis 4, **dadurch gekennzeichnet, dass**
die Resonatorendspiegel gebrochene Kristallfacetten sind und die inneren Resonatorspiegel (5) geätzte Spiegel sind.

6. Halbleiterlaservorrichtung nach einem der Ansprüche 1 bis 5, **dadurch gekennzeichnet, dass**
der Übergang von den Pumpstrahlungsquellen (2) zum Vertikalemissionsbereich (1) gekrümmt ist und sich durch eine Brechungszahländerung auszeichnet, so dass die Pumpstrahlung im Vertikalemissionsbereich (1) fokussiert wird.

## Claims

1. Optically pumped semiconductor laser apparatus having a surface-emitting vertical emission region (1) and at least two monolithically integrated pump radiation sources (2) for optically pumping the vertical emission region (1), the at least two pump radiation sources (2) producing pump radiation and being set up and arranged such that the pump radiation enters the vertical emission region (1) in the form of partial radiation bundles, which come from different pump radiation sources (2) with a different primary radiation direction, in different radiation directions, so that the pump radiation overlaps the fundamental mode of the vertical emission region (1) which is suitable for excitation of this fundamental mode,
**characterized in that**
at least one of the pump radiation sources (2) has a resonator having at least one resonator end mirror arrangement which consists of two straight resonator end mirrors (4) which are arranged at right angles with respect to one another, or at least one of the pump radiation sources (2) has a folded resonator having two resonator end mirrors and at least one inner resonator mirror (5).

2. Semiconductor laser apparatus according to Claim 1,
**characterized in that**
the pump radiation sources (2) are edge-emitting semiconductor lasers.

3. Semiconductor laser apparatus according to one of Claims 1 and 2, **characterized in that**
the two straight resonator end mirrors (4) are arranged such that the pump radiation in the resonator is totally reflected on them.

4. Semiconductor laser apparatus according to one of Claims 1 to 3, **characterized in that**
the at least one inner resonator mirror (5) is arranged such that the pump radiation in the resonator is totally reflected on it.

5. Semiconductor laser apparatus according to one of Claims 1 to 4, **characterized in that**
the resonator end mirrors are broken crystal facets and the inner resonator mirrors (5) are etched mirrors.

6. Semiconductor laser apparatus according to one of Claims 1 to 5, **characterized in that**
the transition from the pump radiation sources (2) to the vertical emission region (1) is curved and is distinguished by a change of refractive index, so that the pump radiation is focused in the vertical emission region (1).

## Revendications

1. Dispositif laser à semi-conducteur et pompage optique, qui présente une zone (1) d'émission verticale qui émet par sa surface et au moins deux sources monolithiques intégrées (2) de rayonnement de pompage qui assurent le pompage optique de la zone (1) d'émission verticale, les deux ou plusieurs sources (2) de rayonnement de pompage créant un rayonnement de pompage et étant installées et disposées de telle sorte que le rayonnement de pompage qui présente la forme de faisceaux partiels de rayonnement qui proviennent de différentes sources (2) de rayonnement de pompage et qui présentent différentes directions principales de rayonnement pénètre dans différentes directions de rayonnement dans la zone (1) d'émission verticale, de telle sorte que le rayonnement de pompage se superpose au mode de base de la zone (1) d'émission verticale d'une manière qui convient pour exciter ce mode de base,
**caractérisé en ce que**
au moins l'une des sources (2) de rayonnement de pompage présente un résonateur doté d'au moins un système de miroirs d'extrémité de résonateur constitué de deux miroirs rectilignes (4) d'extrémité de résonateur disposés l'un par rapport à l'autre à angle droit ou **en ce qu'**au moins l'une des sources (2) de rayonnement de pompage présente un résonateur replié doté de deux miroirs d'extrémité de résonateur et d'au moins un miroir intérieur (5) de résonateur.

2. Dispositif laser à semi-conducteur selon la revendication 1, **caractérisé en ce que** les sources (2) de rayonnement de pompage sont des lasers à semi-conducteur qui émettent par leur chant.

3. Dispositif laser à semi-conducteur selon l'une des revendications 1 ou 2, **caractérisé en ce que** les deux miroirs rectilignes (4) d'extrémité de résonateur sont disposés de telle sorte que le rayonnement de pompage y subit une réflexion totale dans le résonateur.

4. Dispositif laser à semi-conducteur selon l'une des revendications 1 à 3, **caractérisé en ce que** le ou les miroirs intérieurs (5) de résonateur sont disposés de telle sorte que le rayonnement de pompage y subit une réflexion totale dans le résonateur.

5. Dispositif laser à semi-conducteur selon l'une des revendications 1 à 4, **caractérisé en ce que** les miroirs d'extrémité de résonateur sont des facettes cristallines rompues et **en ce que** les miroirs intérieurs (5) du résonateur sont des miroirs gravés.

6. Dispositif laser à semi-conducteur selon l'une des revendications 1 à 5, **caractérisé en ce que** la transition entre les sources (2) de rayonnement de pompage et la zone (1) d'émission verticale est incurvée et se **caractérise par** une modification de l'indice de réfraction telle que le rayonnement de pompage est focalisé dans la zone (1) d'émission verticale.
